# EUROPEAN PATENT APPLICATION

(11) **EP 4 350 768 A1**
(43) Date of publication of application: **10.04.2024**
(21) Application number: 22199972.5
(22) Date of filing: 06.10.2022
(51) Int. Cl.: H01L 27/02, H01L 29/87

(54) **FOUR-LAYER SEMICONDUCTOR DEVICE AND ESD PROTECTION CIRCUIT**

(71) Applicant: Nexperia B.V., 6534 AB Nijmegen (NL)
(72) Inventor: Mergens, Markus, Hamburg (DE)
(74) Representative: Pjanovic, Ilija

(57) **Abstract**

Aspects of the present disclosure generally relate to a four-layer semiconductor device, such as a silicon-controlled rectifier. Further aspects of the present disclosure relate to an electrostatic discharge, ESD, protection circuit comprising the same.

In the four-layer semiconductor device in accordance with the present disclosure, an electrical insulation is provided that extends at least partially inside the epitaxial layer and that prevents a current from flowing between the first device terminal and the second device terminal that does not at least partially flow through the semiconductor substrate.

## Description

Aspects of the present disclosure generally relate to a four-layer semiconductor device. Further aspects of the present disclosure relate to an electrostatic discharge, ESD, protection circuit comprising the same.

### BACKGROUND

One major challenge in the application of silicon-controlled rectifiers, SCRs, in system-level ESD protection devices is the typically low holding voltage Vh of approximately 1.5V. Particularly in high voltage products, the operational voltages of Vop > 5V exceed the holding voltage by far. This bears the risk of unintended ESD triggering during normal operation, i.e. latch-up, and therefore often renders this device type unsuitable. Reason is that for pins that directly or indirectly connect to the supply, such as a car battery, an incorrect triggering of the SCR could result in electrical disturbance of the system or, what is even more serious, the damage of the ESD component due to the high static energy dissipation.

The typical operational voltage limit for standard SCRs is approximately 5V. To increase the holding voltage to a level above the operational voltage, several SCRs are arranged in series. For higher operational voltages, this method is generally not feasible anymore due to substrate parasitics. Of course, fully isolated device technologies, such as those offered when using Silicon-on-Insulator (SOI) material, offer options to increase the holding volage by simple device stacking. However, the downside is a high investment due to silicon real estate and material costs.

### SUMMARY

Aspects of the present disclosure relate to a four-layer semiconductor device in which the abovementioned drawback(s) do not occur, or hardly so.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a four-layer semiconductor device is provided that comprises a semiconductor substrate of a first charge type, and an epitaxial layer arranged on the semiconductor substrate in which a first region of the second charge type and a second region of the second charge type are formed. For example, the first charge type may correspond to p-type and the second charge type to n-type.

The four-layer semiconductor device further comprises a first contact region of the first charge type formed in the first region, and a first device terminal electrically connected to the first contact region. The first device terminal may for example be formed using one or more conductive layers, such as metal layers, that are arranged above and in contact with the first contact region.

The four-layer semiconductor device also comprises a second contact region of the second charge type formed in the second region, and a second device terminal electrically connected to the second contact region. Similar to the first device terminal, the second device terminal may be formed using one or more conductive layers, such as metal layers, that are arranged above and in contact with the second contact region.

The four-layer semiconductor device further comprises an electrical insulation extending at least partially inside the epitaxial layer and that prevents a current from flowing between the first device terminal and the second device terminal that does not at least partially flow through the semiconductor substrate.

In four-layer semiconductor device of the type described above, two bipolar transistors are formed. A first bipolar transistor is formed using the first contact region, which is of the first charge type, the first region, which is of the second charge type, and the semiconductor substrate, which is of the first charge type. A second bipolar is formed using the second contact region and second region, which are both of the second charge type, the semiconductor substrate, which is of the first charge type, and the first region, which is of the second charge type. When the first charge type corresponds to p-type and the second charge type to n-type, the first bipolar transistor corresponds to a PNP transistor having its emitter formed by the first contact region, its base formed by the first region, and its collector by the semiconductor substrate. The second bipolar transistor corresponds to an NPN transistor having its emitter formed by the second region and second contact region, its base by the semiconductor substrate, and its collector by the first region. Consequently, the base of the second bipolar transistor is electrically connected to the collector of the first bipolar transistor, and the base of the first bipolar transistor is electrically connected to the collector of the second bipolar transistor.

The electrical insulation extends at least partially inside the epitaxial layer and so prevents a current from flowing between the first device terminal and the second device terminal that does not at least partially flow through the semiconductor substrate. Put differently, the base of the first bipolar transistor does not have a direct electrical connection with the emitter of the second bipolar transistor. Hence, the base current of the first bipolar transistor must flow via the collector of the second bipolar transistor.

In the abovementioned example in which the first charge type corresponds to p-type and the second charge type to n-type, an unidirectional mode of operation is activated by a sufficient potential increase at the first device terminal relative to the second device terminal. For this specific polarity, the first bipolar transistor can be activated by either avalanche breakdown at the edge of the first region facing the semiconductor substrate or a punch-thru of the depletion region that spans across the first region, although the present application also applies to other mechanisms by which the first or second bipolar transistors can be activated. With the PNP bipolar action, a hole current is injected into the p-type base of the second bipolar transistor, thereby turning it on. In turn, electrons are pumped into the base of the first bipolar transistor, thereby reinforcing its action. Obviously, a typical regenerative process between the two bipolar transistors is started. This results in the well-known self-sustained latch-up operation provided that the transistor current gains, e.g. the ratio between the collector and base currents, of the interlinked PNP and NPN are sufficiently high. For relatively low doping concentrations in bases of the first and second bipolar transistors this is the case resulting in the typical low holding voltage of approximately 1.5V that develops upon triggering into the high-current regime.

More accurately, the latch-up condition for the four-layer semiconductor device to snap back to its typical holing voltage of 1.5V theoretically depends on the current gain product of the first and second bipolar transistors. If the current gain product reaches one, the condition for the regenerative process is fulfilled and the four-layer structure can latch.

A known approach for increasing the holding voltage to higher values is to increase the doping levels in the bases of the first and second bipolar transistors. By this, the transistor current gain is reduced. For silicon-controlled rectifiers, SCRs, which are examples of four-layer semiconductor devices, a similar technique is known for increasing the holding voltage. Such an SCR is referred to as a "frustrated SCR".

According to an aspect of the present disclosure the product of the current gains of the first and/or second bipolar transistors is reduced in a different manner. This reduction is obtained using the electrical insulation that extends through the epitaxial layer and into the semiconductor substrate. In this manner, the effective base length of the first and second bipolar transistors under the electrical insulation is expanded thereby reducing the current gain of the first and/or second bipolar transistors.

It should be noted that the reduction in current gain, and more specifically the current gain product, obtained using the electrical insulation, can be combined with known techniques such as increasing the dopant concentration in the bases of the first and second bipolar transistors.

The semiconductor substrate in the four-layer semiconductor device of the type described above forms a relatively thick region of the first charge type that carries the entire emitter current of the second bipolar transistor and the entire base current of the first bipolar transistor. Within the context of the present disclosure, a semiconductor substrate should be interpreted as a substrate formed by semiconductor material and that may consist of one or more semiconductor layers that provide this functionality. In an embodiment, the semiconductor substrate comprises that part of the four-layer semiconductor device that was formed prior to applying epitaxial growth. For example, the substrate may comprises a 5 to 1000 micrometer thick p-type Si substrate having a dopant concentration in the range between 10¹³ #/cm3 to 10²⁰ #/cm3.

The electrical insulation may extend through the epitaxial layer and into the semiconductor substrate. In this case, current flowing between the first device terminal and the second device terminal is forced to flow through the semiconductor substrate.

The electrical insulation may comprise a first insulation and a second insulation separated from the first insulation, wherein the first insulation is arranged in between the first region and the second insulation, and wherein the second insulation is arranged in between the second region and the first insulation. By using two or more mutually separated insulations that each extend through the epitaxial layer and into the semiconductor substrate, it is possible to effectively increase the length of the base regions of the first and/or second bipolar transistor, thereby reducing the current gain product and increasing the holding voltage.

The electrical insulation may comprise a deep trench isolation. The trenches may be filled with suitable dielectric material. Moreover, if multiple insulations are used, such as the abovementioned first and second insulation, the insulations are preferably identical and have been simultaneously formed.

The first region and the second region may form a contiguous region. In such embodiments, the electrical insulation penetrates through this contiguous region.

The four-layer semiconductor device may further comprise a third contact region of the second charge type formed in the first region, wherein the first device terminal is electrically connected to the third contact region, and a fourth contact region of the first charge type formed in the second region, wherein the second device terminal is electrically connected to the fourth contact region. In this manner, bi-directional operation is obtained. In a first mode of operation, the first contact region and the second contact region are used for conducting at least a majority of the current between the first and second device terminals, and in a second mode of operation, the third contact region and the fourth contact region are used for conducting at least a majority of the current between the first and second device terminals.

The epitaxial layer can be of the first charge type. In this case, the four-layer semiconductor device may further comprise a first well of the second charge type formed in the epitaxial layer and forming the first region, and a second well of the second charge type formed in the epitaxial layer and forming the second region. The first and second wells may form a contiguous well.

Furthermore, the four-layer semiconductor device may comprise a buried third well of the first charge type formed near an interface between the epitaxial layer and the semiconductor substrate, wherein the buried third well is separated from the first well and contacts and/or partially overlaps the semiconductor substrate. The four-layer semiconductor device may also comprise a buried fourth well of the first charge type formed near an interface between the epitaxial layer and the semiconductor substrate, wherein the buried fourth well is separated from the second well and contacts and/or partially overlaps the semiconductor substrate. The buried third well and buried fourth well preferably form a contiguous buried well. Additionally or alternatively, the four-layer semiconductor device may further comprise a buried first implant of the second charge type at or near an edge of the first well that faces the electrical insulation, or when applicable, the first electrical insulation, and a second implant of the first charge type surrounding the electrical insulation. Similarly, the four-layer semiconductor device may comprise a buried third implant of the second charge type at or near an edge of the second well that faces the electrical insulation, or when applicable the second electrical insulation, wherein the buried first implant and the buried third implant are preferably both spaced apart from the second implant.

The buried first implant and second implant create a punch or reach-thru diode within the epitaxial layer. The same holds for the buried third implant and second implant. These implants allow for adjusting the breakdown and triggering voltage of the four-layer semiconductor device. Increasing the distance between these implants results in higher breakdown/triggering voltages due to the fact that a higher punching bias is needed. However, by overlapping these implants, a standard avalanche trigger junction can be created of which its breakdown can be tailored by the diffusion doping levels.

The abovementioned triggering mechanism is one of several different triggering mechanisms by which the four-layer semiconductor device of the present application could be triggered. The present application is not limited this particular triggering mechanism.

In other embodiments, the epitaxial layer is of the second charge type and forms the first and second regions. In this case, the first region may comprise a fifth well of the second charge type in which the first contact region, and when applicable, the third contact region is/are formed, and wherein the second region comprises a sixth well of the second charge type in which the third contact region, and when applicable, the fourth contact region is/are formed. Here, the fifth well and sixth well may form a contiguous well. Furthermore, the first region may comprise a buried seventh well of the second charge type arranged in between the semiconductor substrate and the first region, and being separated from the first region, and the second region may comprise a buried eight well of the second charge type arranged in between the semiconductor substrate and the second region, and being separated from the second region. Here, the buried seventh well and buried eighth well may form a contiguous well.

In embodiments of the four-layer semiconductor device, a dopant concentration in the first region and second region, and/or a dopant concentration in the semiconductor substrate, and/or a dopant concentration in the buried third and/or fourth well, is chosen such that with respect to a triggering voltage Vt and holding voltage Vh of the four-layer semiconductor device (Vt-Vh)/Vt is less than 0.7, more preferably less than 0.5, and even more preferably less than 0.3. Additionally or alternatively, Vh > 1.5V, and more preferably Vh > 2V. These latter values particularly hold if the four-layer semiconductor device is silicon based as for known four-layer semiconductor devices the holding voltage typically corresponds to twice the forward voltage of a PN junction. By applying the concepts of the present application, a holding voltage can be obtained that is significantly more than twice the forward voltage of a PN junction. The skilled person will understand that the forward voltage for other material systems could be different. However, also for such material systems the holding voltage could be increased by applying the concepts of the present application. For example, the holding voltage could more than n times the holding voltage of a known four-layer semiconductor device in a given material system, wherein n is 2, more preferably 4, and more preferably 10.

The four-layer semiconductor device may be a silicon-controlled rectifier, SCR.

According to a further aspect of the present disclosure, an ESD protection device is provided for enabling a discharge current to flow from a node to be protected to a reference node, such as ground. The ESD protection device comprises the four-layer semiconductor device as defined above, wherein the first diode terminal is electrically connected to the node to be protected, and wherein the second diode terminal is electrically connected to the reference node.

### DESCRIPTION OF THE DRAWINGS

Next, the present disclosure will be described in more detail with reference to the appended drawings, wherein:
Figure 1 illustrates a general bi-directional SCR in accordance with an aspect of the present disclosure;
Figure 2 illustrates an implementation of the SCR of figure 1 in which the epitaxial layer has a charge type that is identical to that of the semiconductor substrate; and
Figure 3 illustrates an implementation of the SCR of figure 1 in which the epitaxial layer has a charge type that is different from that of the semiconductor substrate;
Figure 4 illustrates a general bi-directional SCR in accordance with an aspect of the present disclosure;
Figure 5 illustrates an embodiment of a uni-directional SCR in accordance with an aspect of the present disclosure;
Figure 6 illustrates a further embodiment of a uni-directional SCR in accordance with an aspect of the present disclosure; and
Figure 7 illustrates an ESD protection device in accordance with an aspect of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

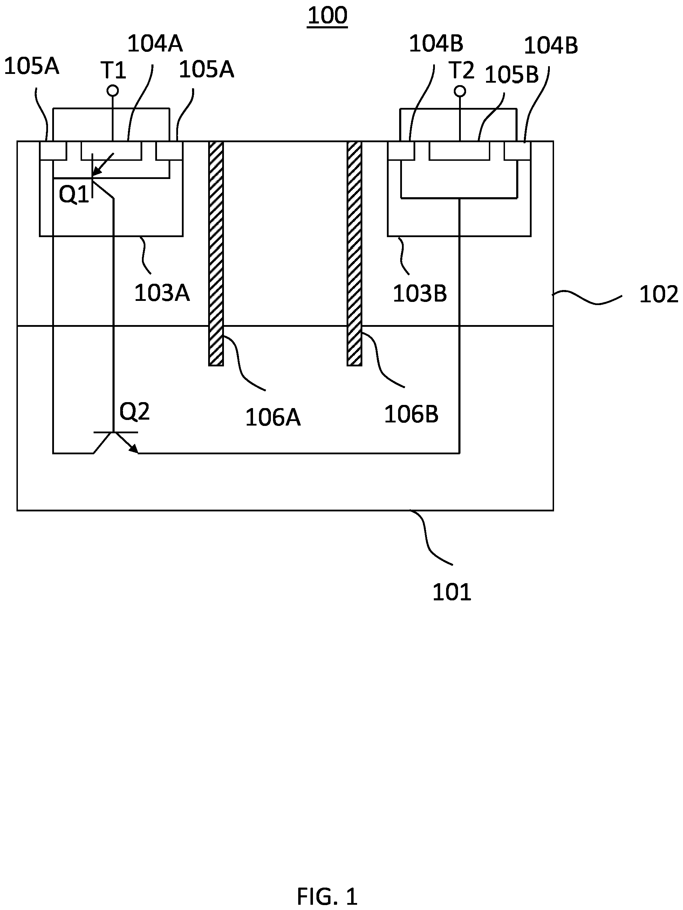

Figure 1 illustrates a general bi-directional SCR 100 in accordance with an aspect of the present disclosure. It comprises a p-type Silicon substrate 101 having a dopant concentration in the range between 10¹³ #/cm3 and 10²⁰ #/cm3 and an epitaxial layer 102 grown on top of substrate 101. Inside epitaxial layer 102, a first n-type region 103A and a second n-type region 103B are formed by ion implantation that each have a dopant concentration in a typical range between 10¹⁷ #/cm3 and 10¹⁹ #/cm3. Inside region 103A, a first p-type contact region 104A and a pair of third n-type contact regions 105A are formed. Inside region 103B, a pair of second n-type contact regions 104B and a fourth p-type contact region 105B are formed. Typical dopant concentrations of regions 104A, 104B, 105A, 105B lie in the range between 10¹⁹ #/cm3 and 10²¹ #/cm3.

SCR diode 100 further comprises a first deep trench isolation 106A and a second deep trench isolation 106B that are spaced apart from each other. Deep trench isolations 106A, 106B comprise high aspect ratio trenches that are optionally filled with oxide or polysilicon.

Figure 1 further illustrates the presence of two bipolar transistors Q1, Q2 that correspond to a first mode of operation in which a voltage applied to first diode terminal T1 is larger than that applied to second diode terminal T2.

As shown, first contact region 104A forms an emitter of first bipolar transistor Q1. The base and collector of that transistor are formed by first n-type region 103A, and p-type substrate 101, respectively. Similarly, second contact regions 104B form an emitter of second bipolar transistor Q2. The base and collector of that transistor are formed by p-type substrate 101, and n-type first region 103A, respectively.

Third n-type contact regions 105A form n-type ties that connect to first region 103A on either side of p-type first contact region 104A. Here, p-type first contact region 104A acts as an anode terminal of SCR 100. The diffusions work in a different fashion on the symmetrically designed right-hand side. Here, second contact regions 104B act as a cathode terminal of SCR 100, whereas p-type fourth contact region 105B remains inactive as it is not forward biased in the first mode of operation in which the voltage applied to first diode terminal T1 is larger than that applied to second diode terminal T2.

Obviously, for reverse polarity the function of the various diffusions is also reversed making this device symmetrical and bi-directional in operation.

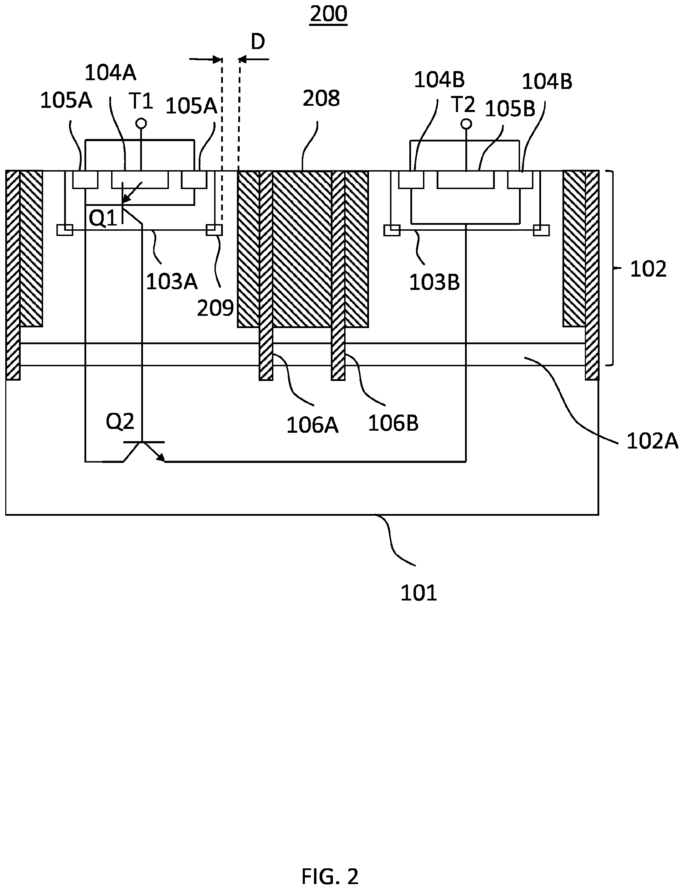

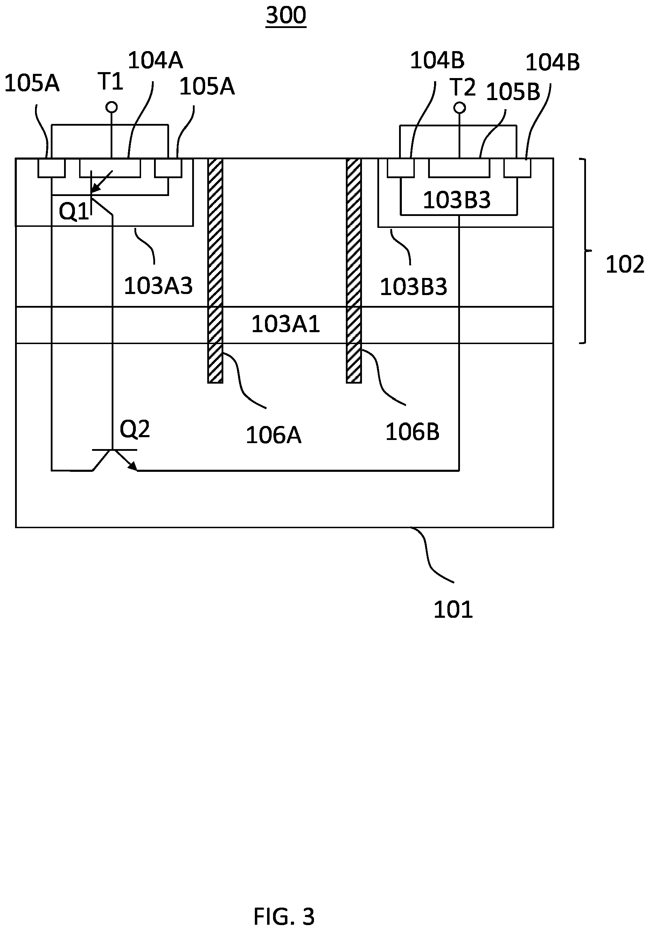

Up to this point, the charge type of epitaxial layer 102 was not discussed. In figures 2, 4, and 6, and even figure 1, examples are provided in which the charge type of epitaxial layer 102 is identical to that of p-type substrate 101. In figures 3, 5, and 6, an example is provided in which the charge type of epitaxial layer 102 is opposite to that of p-type substrate 101.

Hereinafter, other embodiments of the present application will be presented. Components in these embodiments having the same reference signs as components in figure 1 are configured identically as those components in terms of functionality and/or doping type and/or doping levels, unless otherwise stated.

SCR 200, as shown in figure 2, comprises a p-type epitaxial layer 102 having a dopant concentration in the range between 10¹² #/cm3 and #/10¹⁶ cm3. It furthermore comprises a p-type buried layer 102A formed at the interface between epitaxial layer 102 and substrate 101 and having a dopant concentration in the range between 10¹⁶ #/cm3 to 10¹⁸ #/cm3. It should be noted that buried layer 102A can be fully arranged inside epitaxial layer 102, or partially inside epitaxial layer 102 and partially inside semiconductor substrate 101, or fully inside semiconductor substrate 101.

SCR 200 further comprises a p-type implant 208 that surrounds, at least partially, first and second insulations 106A, 106B. The dopant concentration of implants 208 lies in the range between 10¹⁶ #/cm3 and 10¹⁸ #/cm3. A further buried n-type implant 209 is formed near the edge of first region 103A and second region 103B. Implants 208, 209 are mutually separated by a distance D that typically lies in a range between 1 and 50 micrometer. The dopant concentration of implants 209 lies in the range between 10¹⁶ #/cm3 and 10¹⁸ #/cm3.

Implants 208, 209 create a punch or reach-thru diode within epitaxial layer 102. This allows adjusting the breakdown and triggering voltage of SCR 200. Increasing distance D results in higher breakdown/triggering values due to the fact that a higher punching bias is needed. Moreover, overlapping implants 208, 209 can be used as well to create a standard avalanche trigger junction. Its breakdown voltage can be tailored by the diffusion doping levels.

SCR 200 comprises a PNPN structure, with first contact region 104A being the first P region of the PNPN structure, with first region 103A being the first N region of the PNPN structure, with the combination of epitaxial layer 102 including buried layer 102A and semiconductor substrate 101 being the second P region of the PNPN structure, and second region 103B and second contact region 104B being the second N region of the PNPN structure. As described before, trenches 106A, 106B ensure a stretched current path that reduces the current gain product of Q1 and Q2, thereby increasing the holding voltage of SCR 200.

SCR 300, shown in figure 3, comprises an n-type epitaxial layer having a dopant concentration that lies in the range between 10¹⁶ #/cm3 and 10¹⁸ #/cm3. Inside epitaxial layer 102, first and second n-type wells 103A3, 103B3 are formed having a dopant concentration that lies in the range between 10¹⁶ #/cm3 and 10¹⁸ #/cm3. Although shown as separate wells, wells 103A3, 103B3 may form a contiguous well.

SCR 300 further comprises an n-type buried well 103A1 having a dopant concentration that lies in the range between 10¹⁶ #/cm3 and 10¹⁸ #/cm3.

SCR 300 comprises a PNPN structure, with first contact region 104A being the first P region of the PNPN structure, with first regions 103A1-103A3 being the first N region of the PNPN structure, with semiconductor substrate 101 being the second P region of the PNPN structure, and buried well 103A1, epitaxial layer 102, second n-type well 103B3, and second contact regions 104B being the second N region of the PNPN structure.

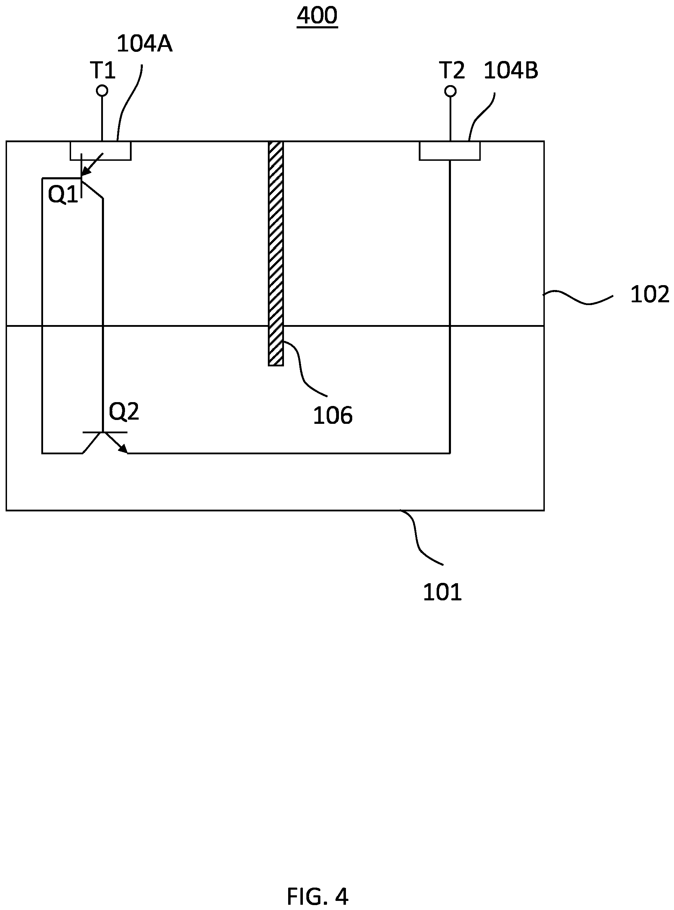

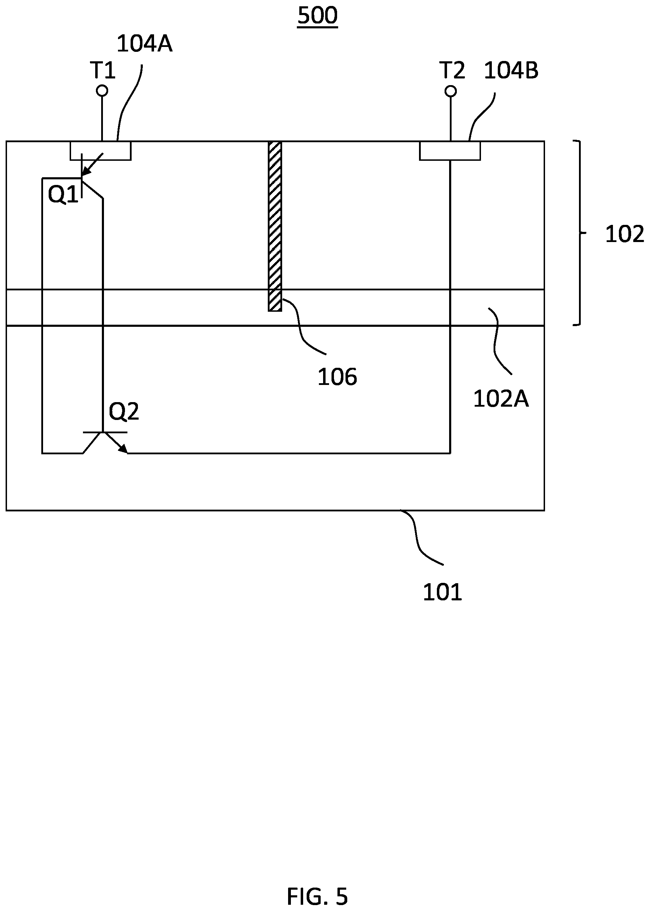

Figures 4 and 5 illustrate uni-directional SCRs 400, 500 in accordance with an aspect of the present disclosure. SCR 400 can be regarded as a uni-directional equivalent of SCR 100 shown in figure 1. SCR 400 can also be referred to as a Shockley diode. In figure 4, SCR 400 comprises a single type of contact on either side of trench 106 and n-type epitaxial layer 102 forms the first and second regions, which in figure 1 are referred to using 103A, 103B.

SCR 500, shown in figure 5, resembles SCR 400 with the exception that a p-type buried implant 102A is arranged near the interface between epitaxial layer 102 and substrate 101. Furthermore, unlike in SCR 100, trench 106 fully extends inside epitaxial layer 102. Moreover, trench 106 does not extend into substrate 101. In this case, current between terminals T1, T2 will flow only partially through substrate 101. Depending on the doping level of buried implant 102A relative to that of substrate 101 more or less of this current will flow through buried implant 102A.

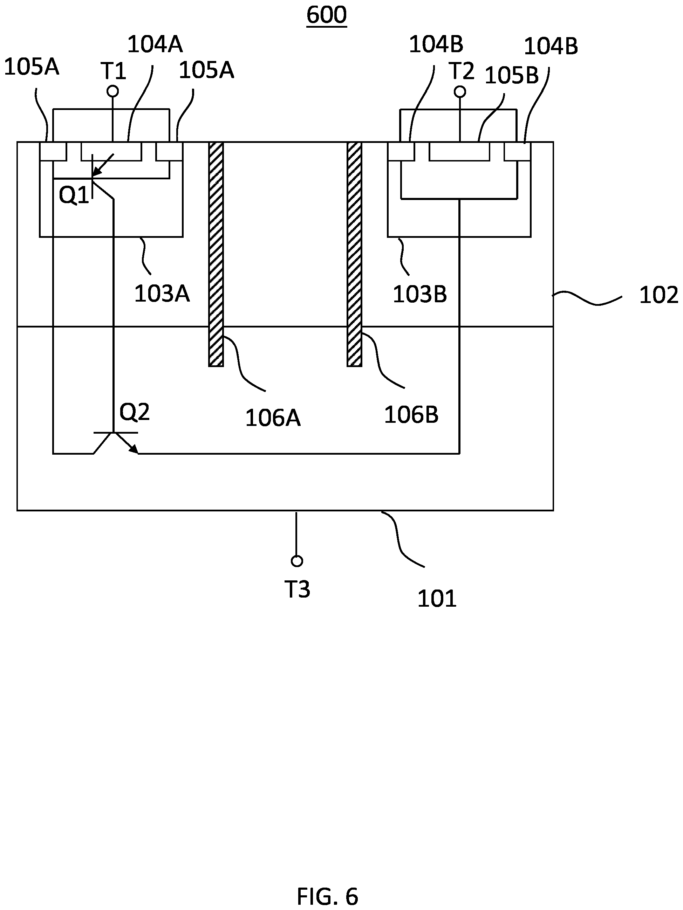

Figure 6 illustrates a general bi-directional SCR 600 in accordance with an aspect of the present disclosure. The structure of SCR 600 is similar to that of SCR 100 with the exception that a third device terminal T3, i.e. the so-called gate terminal, is electrically connected to semiconductor substrate 101.

In figure 6, device terminal T3 is arranged on a backside of the device. The skilled person will however appreciate that various other positions are possible for device terminal T3. In addition, in figure 6, device terminal T3 directly contacts semiconductor substrate 101. Alternative configurations are possible in which semiconductor substrate 101 is electrically contacted, optionally via one or more other semiconductor layers. Furthermore, figure 6 illustrates an SCR 600 based on SCR 100. It is however also possible to construct an SCR based on SCR 200, 300, 400, 500.

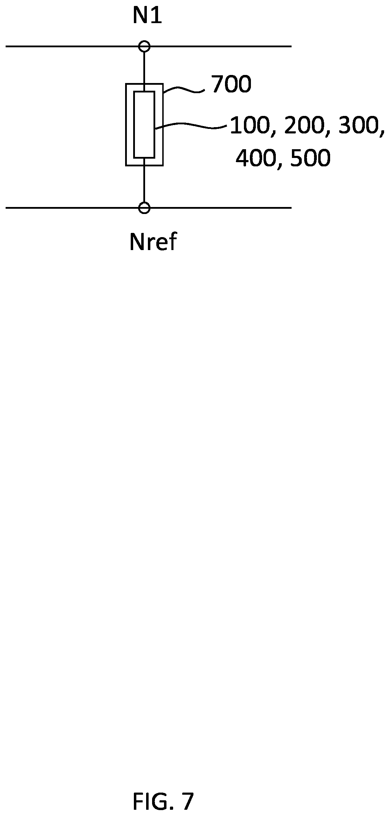

Figure 7 illustrates an ESD protection device 700 in accordance with an aspect of the present disclosure. It comprises a SCR in accordance with an aspect of the present disclosure.

ESD protection device 700 is connected to a node N1 of a device to be protected and to a reference node Nref, such as electrical ground. In an embodiment, first diode terminal T1 is connected to node N1 and second diode terminal T2 to node Nref. In the first mode of operation, current will flow from node N1 through SCR 100, 200, 300, 400, 500 to reference node Nref. In the second mode of operation, current will flow from reference node Nref through SCR 100, 200, 300, 400, 500 to node N1. Here, the first mode of operation is intended to protect node N1 against positive ESD pulses whereas the second mode of operation is intended to protect node N1 against negative ESD pulses.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A four-layer semiconductor device, comprising:
a semiconductor substrate of a first charge type;
an epitaxial layer arranged on the semiconductor substrate and in which a first region of the second charge type and a second region of the second charge type are formed;
a first contact region of the first charge type formed in the first region, and a first device terminal electrically connected to the first contact region;
a second contact region of the second charge type formed in the second region, and a second device terminal electrically connected to the second contact region;
wherein the four-layer semiconductor device further comprises an electrical insulation extending at least partially inside the epitaxial layer and that prevents a current from flowing between the first device terminal and the second device terminal that does not at least partially flow through the semiconductor substrate.

2. The four-layer semiconductor device according to claim 1, wherein the electrical insulation extends through the epitaxial layer and into the semiconductor substrate.

3. The four-layer semiconductor device according to claim 1 or 2, wherein the electrical insulation comprises a first insulation and a second insulation separated from the first insulation, wherein the first insulation is arranged in between the first region and the second insulation, and wherein the second insulation is arranged in between the second region and the first insulation.

4. The four-layer semiconductor device according to any of the previous claims, wherein the electrical insulation, or in so far as depending on claim 3 the first and second insulation, comprise(s) a deep trench isolation.

5. The four-layer semiconductor device according to any of the previous claims, wherein the first region and the second region form a contiguous region.

6. The four-layer semiconductor device according to any of the previous claims, further comprising:
a third contact region of the second charge type formed in the first region, wherein the first device terminal is electrically connected to the third contact region; and
a fourth contact region of the first charge type formed in the second region, wherein the second device terminal is electrically connected to the fourth contact region.

7. The four-layer semiconductor device according to any of the previous claims, wherein the epitaxial layer is of the first charge type, and wherein the four-layer semiconductor device further comprises:
a first well of the second charge type formed in the epitaxial layer and forming the first region; and
a second well of the second charge type formed in the epitaxial layer and forming the second region;
wherein the first well and second well preferably form a contiguous well.

8. The four-layer semiconductor device according to claim 7, further comprising:
a buried third well of the first charge type formed near an interface between the epitaxial layer and the semiconductor substrate, wherein the buried third well is separated from the first well and contacts and/or partially overlaps the semiconductor substrate; and
a buried fourth well of the first charge type formed near an interface between the epitaxial layer and the semiconductor substrate, wherein the buried fourth well is separated from the second well and contacts and/or partially overlaps the semiconductor substrate;
wherein the buried third well and buried fourth well preferably form a contiguous buried well.

9. The four-layer semiconductor device according to any of the claims 7-8, wherein the four-layer semiconductor device further comprises:
a buried first implant of the second charge type at or near an edge of the first well that faces the electrical insulation, or in so far as depending on claim 3 the first electrical insulation;
a second implant of the first charge type surrounding the electrical insulation; and
a buried third implant of the second charge type at or near an edge of the second well that faces the electrical insulation, or in so far as depending on claim 3 the second electrical insulation;
wherein the buried first implant and the buried third implant are preferably both spaced apart from the second implant.

10. The four-layer semiconductor device according to any of the claims 1-6, wherein the epitaxial layer is of the second charge type and forms the first and second regions.

11. The four-layer semiconductor device according to claim 10, wherein the first region comprises a fifth well of the second charge type in which the first contact region, and in so far as depending on claim 6, the third contact region is/are formed, and wherein the second region comprises a sixth well of the second charge type in which the third contact region, and in so far as depending on claim 6, the fourth contact region is/are formed, wherein the fifth well and sixth well preferably form a contiguous well.

12. The four-layer semiconductor device according to any of the claims 10-11, wherein the first region comprises a buried seventh well of the second charge type arranged in between the semiconductor substrate and the first region, and being separated from the first region, and wherein the second region comprises a buried eight well of the second charge type arranged in between the semiconductor substrate and the second region, and being separated from the second region;
wherein the buried seventh well and buried eighth well preferably form a contiguous well.

13. The four-layer semiconductor device according to any of the previous claim, wherein:
a dopant concentration in the first region and second region; and/or
a dopant concentration in the substrate; and/or
a dopant concentration in the buried third and/or fourth well;
is chosen such that with respect to a triggering voltage Vt and holding voltage Vh of the four-layer semiconductor device:
(Vt-Vh)/Vt is less than 0.7, more preferably less than 0.5, and even more preferably less than 0.3; and/or
Vh > 1.5V, and more preferably Vh > 2V.

14. The four-layer semiconductor device according to any of the previous claims, wherein the four-layer semiconductor device is a silicon-controlled rectifier, SCR.

15. An electrostatic discharge, ESD, protection device for enabling a discharge current to flow from a node to be protected to a reference node, such as ground, the ESD protection device comprising the four-layer semiconductor device as defined in any of the previous claims, wherein the first diode terminal is electrically connected to the node to be protected, and wherein the second diode terminal is electrically connected to the reference node.
